# EUROPEAN PATENT SPECIFICATION

(11) **EP 1 326 305 B1**
(45) Date of publication and mention of the grant of the patent: **02.03.2005**
(21) Application number: 01610132.1
(22) Date of filing: 27.12.2001
(51) Int. Cl.: H01R 12/22

(54) **A module with an integrated contact element and an electronic device with such module**
Modul mit einem integrierten Kontaktelement und elektronische Vorrichtung mit einem derartigen Modul
Module avec élement de contact intégré et appareil électronique comportant un tel module

(43) Date of publication of application: 09.07.2003
(73) Proprietor: Telefonaktiebolaget LM Ericsson (publ), 164 83 Stockholm (SE)
(72) Inventor: Hermann, Fredik, 217 54 Malmö (SE); Sandevi, Tommy, 211 26 Malmö (SE)
(74) Representative: Kristoffersen, Bo

(56) References cited:
- US-A- 4 468 074
- US-A- 5 110 298
- PATENT ABSTRACTS OF JAPAN vol. 1998, no. 04, 31 March 1998 (1998-03-31) & JP 09 321529 A (MATSUSHITA ELECTRIC IND CO LTD), 12 December 1997 (1997-12-12)

## Description

### Technical field

The invention relates to a module for an electronic device, said module comprising a base part of a non-conductive material, said base part being provided with at least one conductive pattern that is applied to a surface of the base part, said base part further being provided with at least one protruding contact element that is provided as an integrated part of the base part and has a conductive layer that is in electrical contact with the conductive pattern provided on the surface of the base part.

The invention further relates to an electronic device provided with such a module.

### Related prior art

A module as described above is known from JP-A-9321529 that discloses a radio antenna unit for an electronic device, such as a mobile radio device or a portable telephone set with a built-in antenna. The module comprises a lower casing of the electronic device, and the radiation element or antenna is formed by applying a metal layer by plating, conductive painting or the like onto the inner surface of the lower casing. Ribs are provided as an integral part of the lower casing and the ribs are provided with a conductive layer that is electrically connected to the radiation element. The radiation element is connected to a printed circuit board (PCB) via intermediate contact elements provided on the ribs or at the edge of the PCB. The intermediate contact elements are preferably of an elastically deformable type, such as leaf springs, pogo pins, etc., in order to maintain a good contact between the ribs and the PCB even under different stress conditions.

### Object of the invention

The electrical contact between the radiation element and the PCB according to the prior art requires intermediate contact elements that are to be mounted either on the ribs of the module or at the edge of the PCB. This means that a specific mounting procedure is to be performed in which these intermediate contact elements are mounted on the ribs of the module or on the edge of the PCB. This procedure increases the manufacturing costs due to protracted production time and expenses for the necessary components.

It is therefore an object of the invention to provide a module for use in an electronic device as mentioned in the introductory paragraph in which the need for intermediate contact elements is eliminated.

### Summary of the invention

The object of the invention is achieved by arranging the module mentioned in the introductory paragraph so that the contact element protrudes from the base part in such a way that it may be elastically deformed in a direction essentially perpendicular to said surface of the base part.

Thereby is obtained that the module can be electrically connected directly to the PCB without any need for intermediate contact elements as it is the case in the prior art arrangement. The electrical contact will be very reliable since the elasticity of the protruding contact element(s) ensures that a constant pressure is provided between the contact element(s) and the PCB, when the two parts are held together.

In a preferred embodiment the conductive pattern provided on the base part of the module forms an antenna. By providing the antenna directly on the module it is possible to provide an internal antenna in the electronic device.

The protruding contact element(s) may take any suitable form applicable in the relevant application. In a first embodiment the protruding contact element has the shape of a hook. In a second embodiment the protruding contact element has a contact part that is essentially parallel with the surface of the base part provided with the conductive pattern In a third embodiment the protruding contact element is inclined in relation to the surface of the base part. In a fourth embodiment the protruding contact element has the shape of a bow with each end connected to the base part. Other shapes of the protruding contact element(s) are possible, it being important, however, that the configuration must call for flexible and elastic contact element(s) that ensure(s) full electrical contact between the module and the PCB at all times.

Preferably, the base part as well as its integrated protruding contact element(s) is made of plastics which makes it possible to keep the production costs at a very low level.

In order to minimise the number of elements forming the electronic device, a surface of the base part opposite the surface provided with the conductive pattern is intended to form an outer surface of an electronic device. Thereby, the module becomes a part of the casing as such of the electronic device and not a separate component that is positioned within the casing.

An electronic device according to the invention comprises a casing and a printed circuit board (PCB) and other relevant components. It also comprises a module as described above, which constitutes at least a part of the casing, and the protruding contact element(s) of the module abut(s) on the PCB.

The electronic device may be a mobile radio communication device, preferably a mobile phone.

It shall be emphasised that the term "comprise/comprising" when used in this specification is taken to specify the presence of stated features, integers, steps or components but does not preclude the presence or addition of one or more other features, integers, steps components or groups thereof.

### Description of the drawings

The invention will be described in detail in the following with reference to the drawings in which
Fig. 1 shows a cross-section of an electronic device in the form of a mobile phone provided with a module according to the invention;
Fig. 2 shows the module used in the mobile phone in Fig. 1 in perspective; and
Figs 3a-3c show variations of different configurations of a module according to the invention.

### Detailed description of an embodiment of the invention

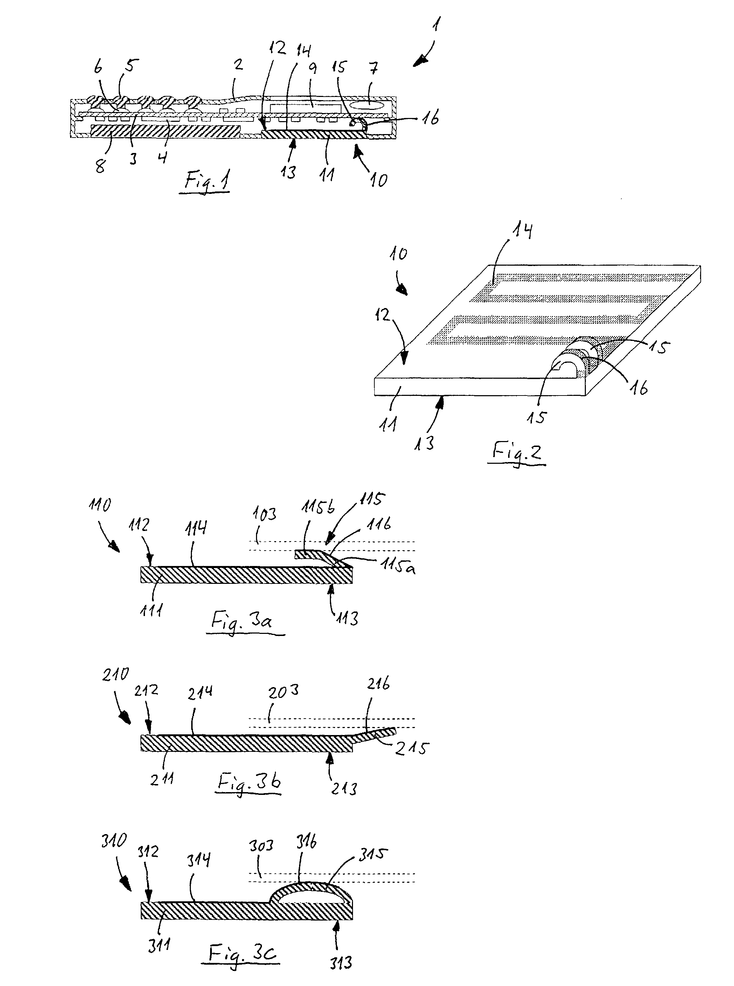

Fig. 1 shows a cross-section of an electronic device in the form of a mobile phone 1. The mobile phone 1 comprises an outer shell-shaped casing 2 that defines the general outer shape of the mobile phone 1. The mobile phone 1 is provided with various components generally known in the art of mobile phones, such as a PCB 3 (printed circuit board) provided with various electronic components 4, keys 5 that extend through openings in the casing to abut on contacts 6 provided in connection with the PCB 3, and other components, such as a loudspeaker 7, a battery 8, an LCD 9, etc.

A module 10 according to the invention is also provided. The module 10 comprises a base part 11 with an interior surface 12 and an external surface 13, the latter forming part of the outer surface of the mobile phone 1. A conductive pattern 14 has been applied to the interior surface 12 to form e.g. an internal antenna for the mobile phone 1. The base part 11 is provided with two protruding contact elements 15 (only one is seen) that are provided as integrated parts of the base part, i.e. the contact elements 15 and the base part 11 is made in one piece, and the contact elements 15 are provided with a conductive layer 16 that is in electrical contact with the conductive pattern 14 provided on the interior surface 12 of the base part 11.

The protruding contact elements 15 provides for electrical contact between the PCB 3 and the antenna in the form of the conductive pattern 14 provided on the interior surface 12 by abutting on relevant areas of the PCB 3.

The module 10 is shown in larger detail and in perspective in Fig. 2. The module 10 may be made of any suitable material, e.g. a thermoset material like epoxy, a ceramic material or a thermoplastic material. The material must, however, exhibit good elastic properties and in case the conductive pattern 14 constitutes an internal antenna, the dielectric properties of the material must allow the antenna signal to successfully penetrate the material.

Preferably, the module 10 is made by injection moulding of a thermoplastic material, such as PEI (poly ether imide), PPO (poly phenylene oxide), LCP (liquid crystal polymer), SPS (syndiotactic polystyrene), ABS (acrylnitril butadiene styrene).

As mentioned above, the module 10 comprises a base part 11 and two contact elements 15 protruding from the base part 11. In the shown embodiment the contact elements 15 are shaped as elastically deformable hooks that protrude from the interior surface 12 of the base part 11.

The conductive pattern 14 forms an antenna that is in electrical contact with a similar conductive layer 16 provided at the outer surfaces of the hook-shaped protruding contact elements 15. Due to the design of the module 10, the conductive layers 16 on the contact elements 15 are provided not only on the upper surface thereof, but - at least partly - also circumferentially at the base area of the contact elements 15 as shown in Fig. 2. Thereby, the electrical contact between the conductive pattern 14 and the conductive layers 16 is ensured. Alternatively, the conductive layers 16 could cover the whole surface of the protruding contact elements 15.

The conductive pattern 14 as well as the conductive layer 16 may be provided by a number of different methods, such as pad printing, spray coating, sputtering or other types of vacuum metallisation, hot embossing or plating. For pad printing, inks containing e.g. copper or silver particles can be used and the same metals are commonly used for spray coating. For sputtering, metals such as aluminium, gold, copper and nickel are used. For other types of vacuum metallisation, aluminium is commonly used.

However, for wear resistance reasons, wet plating (chemical and/or galvanic) is the preferred method for applying the conductive pattern 14 and the conductive layer 16. Preferably, a selective plating process is used to avoid unwanted stiffness increase, especially when applying the conductive layer 16 onto the contact elements 15. Selective plating can be accomplished in a number of ways, such as photo imaging with photoresist, laser imaging combined with etching, a two-shot moulding process, where one material is plateable and the other is not, etc.

Suitable plating metals include nickel, copper, palladium or gold. When copper is used in a humid and aggressive environment it will oxidise and become non-conductive and should therefore be covered by another metal layer, preferably nickel. In connector areas, a top layer of e.g. gold on the nickel layer is preferred, whereas nickel is generally considered sufficient in other areas.

The above-mentioned techniques are all well-known and a person skilled in the art will easily adapt these techniques to provide a conductive pattern 14 and a conductive layer to a module 10 according to the invention.

Figs 3a-3c disclose three modules 110,210,310 with three different designs of the protruding contact elements 115,215,315. The modules 110,210,310 are shown from one side only, but it is to be understood that contact elements 115,215,315 of each module 110,210,310 comprise at least one narrow, resilient part that protrudes from the base part 111,211,311 of the module 110,210,310. Preferably, there is provided two contact elements 115,215,315 on each module 110,210,310 as it is the case with the module 10 shown in Figs 1-2.

In Fig. 3a each of the protruding contact elements 115 comprises an inclined connecting part 115a and a contacting part 115b that is essentially parallel with the interior (upper) surface 112 of the base part 111. A PCB 103 is shown in dotted lines and it is shown how the contacting part 115b of the contact element 115 abuts on the PCB 103. The resiliency of the contact element 115 is not shown in detail, but the base part 111 and the contact element 115 are made in one piece of a material that allows the contact element 115 to be elastically deformed when the module 110 is forced against the PCB 103. The resiliency of the contact element 115 maintains the pressure against the PCB 103 after assembly of the electronic device in which the module 110 and the PCB 103 are used.

Even though it is not directly shown, the conductive layer 116 provided on the contact element 115 is in electrical contact with the conductive pattern 114 provided on the interior surface 112 of the base part 111 in a manner similar to that shown in Fig. 2 and described above.

Fig. 3b shows a module 210 in which each protruding contact element 215 is inclined in relation to the interior surface 212 of the base part 211. In contrast to the embodiment shown in Fig. 3a in which the contact elements 115 extend above and over the base part 111, the contact elements 215 of the embodiment shown in Fig. 3b extend away from the base part 211. By this arrangement of the contact element 215 the PCB 203 can be positioned closer to the module 210 than is the case with the modules 10,110 shown in Figs 1, 2 and 3a.

This configuration of the contact elements 215 also calls for a simpler manufacturing mould if the module 210 is made by injection moulding since there are no overlapping areas.

Fig. 3c shows yet another embodiment for a module 310 according to the invention. In this module each of the protruding contact elements 315 is shaped like a bow that is connected to the base part 311 at each end. This embodiment is quite similar to the embodiment shown in Figs 1-2, but entails a less risk of damage or dislocation of the contact elements 315 since the contact elements 315 have no free ends.

The above-described embodiments for a module according to the invention are to be taken as illustrative examples only. The base part 11,111,211,311 is shown as a flat, plate-shaped article, but it may of course be given any relevant form that is suitable for a certain application. It may be plate-like as shown or it could be shaped like a shell that forms a substantial part of the outer casing of an electronic device, such as a mobile phone.

Likewise, the protruding contact elements 15,115,215,315 may take any suitable form as long as they can be elastically deformed when the module is forced against a PCB or any other relevant component.

## Claims

1. A module (10; 110; 210; 310) for an electronic device, said module comprising a base part (11; 111; 211; 311) of a non-conductive material, said base part being provided with at least one conductive pattern (14;114;214;314) that is applied to a surface (12;112;212;312) of the base part, said base part further being provided with at least one protruding contact element (15;115;215;315) that is arranged to provide electrical contact between a PCB and the conductive pattern by abutting on the PCB, said protruding contact element (15;115;215;315) being provided as an integrated part of the base part and has a conductive layer (16;116;216;316) that is in electrical contact with the conductive pattern provided on the surface of the base part, **characterised in that** said contact element (15;115;215;315) protrudes from the base part (11;111;211;311) in such a way that it may be elastically deformed in a direction essentially perpendicular to said surface (12;112;212;312) of the base part when it is arranged to abut on a PCB.

2. A module according to claim 1, **characterised in that** the conductive pattern (14;114;214;314) provided on the base part forms an antenna.

3. A module according to claim 1 or 2, **characterised in that** the protruding contact element (15) has the shape of a hook.

4. A module according to claim 1 or 2, **characterised in that** the protruding contact element (115) has a contact part (115b) that is essentially parallel with said surface (112) of the base part (111).

5. A module according to claim 1 or 2, **characterised in that** the protruding contact element (215) is inclined in relation to said surface (212) of the base part (211).

6. A module according to claim 1 or 2, **characterised in that** the protruding contact element (315) has the shape of a bow with each end connected to the base part (311).

7. A module according to any one of claims 1-6, **characterised in that** the base part (11;111;211;311) as well as its integrated protruding contact element (15;115;215;315) is made of plastics.

8. A module according to any one of claims 1-7, **characterised in that** a surface (13;113;213;313) of the base part opposite the surface (12;112;212;312) provided with the conductive pattern (14;114;214;314) is intended to form an outer surface of an electronic device (1).

9. An electronic device comprising a casing (2) and a printed circuit board (PCB) (3), **characterised in that** it also comprises a module (10;110;210;310) according to any one of claims 1-7, a surface (13;113;213;313) of said module constituting at least a part of said casing (2), and that the at least one protruding contact element (15;115:215:315) of the module abuts on the PCB (3).

10. An electronic device according to claim 9, **characterised in that** it is a mobile radio communications device.

11. An electronic device according to claim 10, **characterised in that** it is a mobile phone (1).

## Patentansprüche

1. Modul (10;110;210;310) für eine elektronische Vorrichtung, wobei das besagte Modul ein Basisteil (11;111;211;311) aus einem nichtleitenden Material aufweist, wobei der besagte Basisteil mit mindestens einem leitenden Muster (14;114;214;314) versehen ist, welches auf einer Oberfläche (12;112;212;312) des Basisteils aufgetragen wird, wobei das besagte Basisteil weiterhin versehen ist mit mindestens einem überstehenden Kontaktelement (15;115;215;315), welches so angeordnet ist, um einen elektrischen Kontakt zwischen einer Leiterplatte (PCB) und dem leitenden Muster durch Anstoss an die Leiterplatte (PCB) zu liefern, wobei das besagte überstehende Kontaktelement (15;115;215;315) als ein integriertes Teil des Basisteils geliefert wird und eine leitende Schicht (16;116;216;316) aufweist, die in elektrischem Kontakt mit dem leitenden Muster steht, welches auf der Oberfläche des Basisteils vorgesehen ist, **dadurch gekennzeichnet, dass** das besagte Kontaktelement (15;115;215;315) aus dem Basisteil (11;111;211;311) in solch einer Weise übersteht, dass es in elastischer Weise in einer Richtung deformiert werden kann, welche im Wesentlichen senkrecht zu der besagten Oberfläche (12;112;212;312) des Basisteils stehen kann, wenn es angeordnet ist, um an eine Leiterplatte (PCB) anzustossen.

2. Modul nach Anspruch 1, **dadurch gekennzeichnet, dass** das leitende Muster (14;114;214;314), welches auf dem Basisteil vorgesehen ist, eine Antenne bildet.

3. Modul nach Anspruch 1 oder 2, **dadurch gekennzeichnet, dass** das überstehende Kontaktelement (15) die Form eines Hakens aufweist.

4. Modul nach Anspruch 1 oder 2, **dadurch gekennzeichnet, dass** das überstehende Kontaktelement (115) ein Kontaktteil (115b) aufweist, das im wesentlichen parallel zu der besagten Oberfläche (112) des Basisteils (111) steht.

5. Modul nach Anspruch 1 oder 2, **dadurch gekennzeichnet, dass** das überstehende Kontaktelement (215) in Bezug auf die besagte Oberfläche (212) des Basisteils (211) geneigt ist.

6. Modul nach Anspruch 1 oder 2, **dadurch gekennzeichnet, dass** das überstehende Kontaktelement (315) die Form eines Bogens aufweist, wobei jedes Ende mit dem Basisteil (311) verbunden ist.

7. Modul nach einem der Ansprüche 1 bis 6, **dadurch gekennzeichnet, dass** sowohl das Basisteil (11;111;211;311) als auch sein integriertes überstehendes Kontaktelement (15;115;215;315) aus Kunststoff bestehen.

8. Modul nach einem der Ansprüche 1 bis 7, **dadurch gekennzeichnet, dass** eine Oberfläche (13;113;213;313) des Basisteils, die gegenüber der Oberfläche (12;112;212;312) mit dem leitenden Muster (14;114;214;314) angeordnet ist, dafür vorgesehen ist, eine äussere Oberfläche einer elektronischen Vorrichtung (1) zu bilden.

9. Elektronische Vorrichtung mit einem Gehäuse (2) und mit einer Leiterplatte (PCB) (3), **dadurch gekennzeichnet, dass** sie auch ein Modul (10;110;210;310) nach einem der Ansprüche 1 bis 7 umfasst, wobei eine Oberfläche (13;113;213;313) des besagten Moduls mindestens einen Teil des besagten Gehäuses (2) ausbildet und dass das mindestens eine überstehende Kontaktelement (15;115;215;315) des Moduls gegen die Leiterplatte (PCB) (3) anstösst.

10. Elektronische Vorrichtung nach Anspruch 9, **dadurch gekennzeichnet, dass** es sich um eine mobile Funkkommunikations-Vorrichtung handelt.

11. Elektronische Vorrichtung nach Anspruch 10, **dadurch gekennzeichnet, dass** es ein Mobiltelefon (1) ist.

## Revendications

1. Module (10;110;210;310) pour un appareil électronique, où ledit module comprend élément de base (11;111;211;311) fait d'un matériel non-conducteur, où ledit élément de base est équipé avec au moins un dessin conducteur (14;114;214;314), qui est appliqué sur une surface (12;112;212;312) de l'élément de base, où ledit élément de base est en outre muni d'au moins un élément de contact (15;115;215;315) saillant, qui est arrangé d'une manière à livrer un contact électrique entre une carte imprimée (PCB) et le dessin conducteur en aboutissant à la carte imprimée (PCB), où ledit élément de contact (15;11.5;215;315) saillant est livré en tant qu'élément intégré de l'élément de base et comprend une couche conductrice (16;116;216;316), qui se trouve en contact électrique avec le dessin conducteur, qui est prévu sur la surface de l'élément de base, **caractérisé en ce que** ledit élément de contact (15;115;215;315) dépasse l'élément de base (11;111;211;311) d'une telle manière, qu'il peut être déformé par élasticité dans une direction, qui est essentiellement perpendiculaire à ladite surface (12.;112;212;312) de l'élément de base, quand il est arrangé pour aboutir contre une carte imprimée (PCB).

2. Module suivant la revendication 1, **caractérisé en ce que** le dessin conducteur (14;114;214;314), qui est prévu sur l'élément de base, forme une antenne.

3. Module suivant la revendication 1 ou 2, **caractérisé en ce que** l'élément de contact (15) saillant comprend la forme d'un crochet.

4. Module suivant la revendication 1 ou 2, **caractérisé en ce que** l'élément de contact (115) saillant comprend un élément de contact (115b), qui est essentiellement orienté en parallèle à ladite surface (112) de l'élément de base (111).

5. Module suivant la revendication 1 ou 2, **caractérisé en ce que** l'élément de contact (215) saillant est incliné par rapport à ladite surface (212) de l'élément de base (211).

6. Module suivant la revendication 1 ou 2, **caractérisé en ce que** l'élément de contact (315) saillant comprend la forme d'un arc, où chaque extrémité est reliée avec l'élément de base (311).

7. Module suivant l'une des revendications 1 bis 6, **caractérisé en ce qu'**aussi bien l'élément de base (11;111;211;311) que son élément de contact (15;115;215;315) saillant intégré sont faits en plastique.

8. Module suivant l'une des revendications 1 bis 7, **caractérisé en ce qu'**une surface (13;113;213;313) de l'élément de base, étant disposée en face de la surface (12;112;212;312) avec le dessin conducteur (14;114;214;314), est prévue pour former une surface extérieure d'un appareil électronique (1).

9. Appareil électronique avec un boîtier (2) et avec une carte imprimée (PCB) (3), **caractérisé en ce qu'**il comprend aussi un module (10;110;210;310) suivant l'une des revendications 1 à 7, où une surface (13;113;213;313) dudit module forme au moins une partie dudit boîtier (2), et **en ce qu'**au moins un élément de contact (15;115;215;315) saillant du module aboutit contre la carte imprimée (PCB) (3).

10. Appareil électronique suivant la revendication 9, **caractérisé en ce qu'**il s'agit d'un appareil de communication radio mobile.

11. Appareil électronique suivant la revendication 10, **caractérisé en ce qu'**il s'agit d'un téléphone mobile (1).
